# EUROPEAN PATENT SPECIFICATION

(11) **EP 1 867 758 B1**
(45) Date of publication and mention of the grant of the patent: **31.10.2018**
(21) Application number: 07003576.1
(22) Date of filing: 21.02.2007
(51) Int. Cl.: C30B 7/12, C30B 29/04, C30B 29/60

(54) **METHOD OF MANUFACTURING HEXAGONAL NANOPLATE DIAMOND**
VERFAHREN ZUR HERSTELLUNG VON HEXAGONALEN NANOKRISTALLEN DIAMANTEN
PROCÉDÉ DE FABRICATION DE NANOCRISTAUX HEXAGONAUX DE DIAMANT

(30) Priority: 30.05.2006 KR 20060048542
(43) Date of publication of application: 19.12.2007
(73) Proprietor: Korea University Foundation, Seongbuk-gu Seoul (KR)
(72) Inventor: Kim, Young Keun, Gangnam-gu Seoul (KR); Lee, Ju Hun, Gangnam-gu Seoul (KR); Wu, Jun-Hua, Singapore 643668 (SG); Liu, Hong-Ling, Henan (CN); Cho, Ji Ung, Uiwang-si Gyeonggi-do (KR); Min, Ji Hyun, Gwanak-gu Seoul (KR)
(74) Representative: Dr. Gassner & Partner mbB

(56) References cited:
- CAO C ET AL: "Electrodeposition diamond-like carbon films from organic liquids" THIN SOLID FILMS, ELSEVIER-SEQUOIA S.A. LAUSANNE, CH, vol. 368, no. 2, June 2000 (2000-06), pages 203-207, XP004203962 ISSN: 0040-6090
- CHEN ET AL: "Characteristics of ultra-nano-crystalline diamond films grown on the porous anodic alumina template" DIAMOND AND RELATED MATERIALS, ELSEVIER SCIENCE PUBLISHERS, AMSTERDAM, NL, vol. 15, no. 2-3, February 2006 (2006-02), pages 324-328, XP005333783 ISSN: 0925-9635
- MASUDA H ET AL: "SYNTHESIS OF WELL-ALIGNED DIAMOND NANOCYLINDERS" ADVANCED MATERIALS, WILEY VCH, WEINHEIM, DE, vol. 13, no. 4, 19 February 2001 (2001-02-19), pages 247-249, XP001004979 ISSN: 0935-9648

## Description

### BACKGROUND OF THE INVENTION

### 1. Field of the Invention

The present invention relates generally to a method of manufacturing a nanoplate diamond, and more particularly, to a method of manufacturing a hexagonal nanoplate diamond using an electrochemical method.

### 2. Description of the Related Art

A diamond is a particularly useful material having various applications because it has various excellent properties, such as an extreme hardness, a low thermal expansion coefficient, a high thermal conductivity, an excellent electric property, a chemical inertness, a biological compatibility, a low friction, a wear resistance, a negative electron affinity, and an optical transparence.

Recently, active researches are being made on various applications of a diamond. Particularly, researches on a synthesis of a strong structure using a diamond coating that utilizes strength of a diamond, researches on an application of an electric and circuit property of a diamond to an electronics industry, and researches on applications of a diamond to a conventional transistor, a sensor material and a solar cell are in progress. Therefore, the application fields of a diamond will gradually extend.

Also, many researches on a utilization of a diamond nanocrystal are being conducted in various fields such as a research on using carbon, which is a biocompatible atom, as a biocompatible material in a substrate for a bio-sensor. Such a biotechnology is in the limelight recently.

The reason researches on the utilization of the diamond nanocrystal are actively conducted is that the most interesting subject in recent biological applications is to find a material that can be not only applied to a microelectronic process, but also used as a biocompatible material. It is difficult to apply Si, glass, Au and other materials that have been used in a conventional method to biological applications, because they could not sufficiently satisfy both the conditions of being adequate to a microelectronic process and being adequate to be used as a biocompatible material. However, a diamond can be used for a material satisfying both an excellent electronic property and a biocompatibility, thus can overcome the limitations of the conventional materials. Therefore, vigorous researches are being made on an application of a diamond to bio industries.

The method for modifying deoxyribonucleic acid (DNA) based on a stable and biologically active substrate with a crystalline nano-diamond thin film is reported in Nature Materials by Robert J. Hamers et al. in U.S.A., in the year 2003. The method, which could be used for a biosensor, is significant in that diamonds were used in the manufacturing process. It is expected that a worldwide market for a biosensor will reach 4.3 billion dollars in 2011, expanding from 1.9 billion dollars in 2001, and the annual growth rate thereof will reach 9.4% in 2011(Frost & Sullivan, 'World Biosensors Market', 2005. 4). It is also estimated that the worldwide market for a biochip will reach 3 billion dollars in 2007, expanding at an annual growth rate of 33 % from 1 billion dollars in 2003(Global Industry Analysis Inc., 'Biochips', 2004). Thus, if a diamond can be used as a substrate for a biosensor by making best use of its own characteristics, the marketability of the diamond in a gradually growing bio market may increase beyond imagination.

Diamond is a material having such important characteristics; however, the amount of a diamond that can be obtained from nature is finite. Thus, many researches, such as a high-pressure-high-temperature (HPHT), a chemical Vapor deposition (CVD), a homo-epitaxial growth and a hetero-epitaxial growth, have been made for synthesizing a diamond.

Vigorous researches are being made on a method for synthesizing a diamond-like carbon (DLC) and a diamond based on carbon and on a commercialization of the same in many countries headed by USA, England and Japan. For example, a method for synthesizing a diamond plate of a unique shape after coating Ni on a polycrystalline diamond plate using a microwave plasma chemical vapor deposition is described in Journal of Materials Research, Hou-Guang Chen, Li Chang, Vol. 20, pp. 703∼711 (2005).

Also, a method for an epitaxial growth on a sapphire plate using vacuum vapor deposition in an oxidizing atmosphere is described in Nature, Mamoru Yoshimoto, Kenji Yoshida, Hideaki Maruta, Yoshiko Hishitani, Hideomi Koinuma, Shigeru Nishio, Masato Kakihana, and Takeshi Tachibana, Vol. 399, pp. 340∼342 (1999).

However, the conventional synthesizing methods generally include CVD accompanied with a high temperature heat treatment. Thus, the synthesizing process has the problem of a complicated process and increased manufacturing costs because of the high temperature heat treatment.

Therefore, there is a need to provide a simple and inexpensive method of manufacturing a diamond that does not require a high temperature process.

Further, there is a need to provide a method for manufacturing a diamond of a uniform surface, thickness, size and shape, so that the diamond could be applied to industries easily.

Cao C. et al., "Electrodeposition diamon-like carbon films from organic liquids", Thin Solid Films, Elsevier-Sequoia S.A., Lausanne, CH, Vol. 368, No. 2, (2000-06), pages 203-207 describes the preparation of diamond-like carbon films on ITO coated glasses by means of electrochemical deposition from various organic liquids, namely methanol, ethanol, acetonitrile (CH₃CN) and N,N-dimethylformamide (HCON(CH₃)₂).

Chen et al., "Characteristics of ultra-nano-crystalline diamond films grown on the porous anodic alumina template", Diamond and related materials, Elsevier Science Publishers, Amsterdam, NL, Vol. 15, No. 2-3, (20006-02), pages 324-328) describes the synthesis of nanodiamond films containing uniformely small diamond grains (< 20 nm) on a layer of porous anodic alumina formed on a Si substrate. The nanodiamond films thus produced are patterned by the porous anodic alumina layer.

### SUMMARY OF THE INVENTION

An object of the present invention is to substantially solve at least the above problems and/or disadvantages and to provide at least the advantages below. Accordingly, an object of the present invention is to provide a method of manufacturing a diamond that does not require a high temperature heat treatment.

Another object of the present invention is to provide a method of manufacturing a diamond in a nanoplate shape of a uniform surface, thickness, size and shape.

According to one aspect of the present invention, there is provided a method of manufacturing a nanoplate diamond, the method including the steps of providing a nanotemplate having a plurality of holes, forming a nanoplate diamond in the holes of the nanotemplate using an electrochemical method, and separating the nanoplate diamond by removing the nanotemplate.

According to another aspect of the present invention, there is provided a method of manufacturing a nanoplate diamond, the method including the steps of depositing a conductor at a bottom of the nanotemplate having a plurality of holes, forming a nanoplate diamond in the holes of the nanotemplate using an electrochemical method, and separating the nanoplate diamond by removing the nanotemplate.

In addition, other embodiments according to a modification or an addition of an element of the above described method of manufacturing a nanoplate diamond may be provided.

### BRIEF DESCRIPTION OF THE DRAWINGS

The above and other objects, features and advantages of the present invention will become more apparent from the following detailed description when taken in conjunction with the accompanying drawings in which:
FIG. 1 is a schematic diagram illustrating a process for manufacturing a nanoplate diamond according to an embodiment of the present invention;
FIG. 2 is a transmission electron micrograph of a hexagonal nanoplate diamond which is formed using a method according to an embodiment of the present invention;
FIG. 3 is a photograph showing a plurality of hexagonal nanoplate diamonds which is uniformly grown using a method according to an embodiment of the present invention, and a transmission electron micrograph of a diamond single crystal illustrating plane directions of one of hexagonal nanoplate diamonds is also shown at the top left of the figure;
FIG. 4 is a photograph showing an electron diffraction pattern of a hexagonal nanoplate diamond formed using a method according to an embodiment of the present invention, which shows that the diamond is grown to be a single crystal;
FIG. 5 is a high resolution electron micrograph showing a lattice structure of a hexagonal nanoplate diamond formed using a method according to an embodiment of the present invention, which shows that side surfaces are at 30 degrees with respect to the (111) plane and a fringe spacing is 0.28 nm; and
FIG. 6 is a high resolution electron micrograph of a hexagonal nanoplate diamond formed using a method according to an embodiment of the present invention, and a photograph showing a Fourier transformation pattern of [111] projection lattice is also shown at the top right of the figure.

### DETAILED DESCRIPTION OF THE PREFERRED EMBODIMENTS

Preferred embodiments of the present invention will be described herein below with reference to the accompanying drawings. In the following description, well-known functions or constructions are not described in detail since they would obscure the invention in unnecessary detail.

Hereinafter, a method of manufacturing a hexagonal nanoplate diamond will be described in detail.

The present invention relates to a method of manufacturing a hexagonal nanoplate diamond using an electrochemical method, especially an electrodeposition.

According to an embodiment of the present invention, a nano-diamond is epitaxially grown through an electrochemical method using a nanotemplate. The nano-diamond has characteristic properties different from those of a bulk diamond because it is nano-sized.

According to an embodiment of the present invention, an electrochemical method such as electrodeposition using an anodized aluminum oxide (AAO) is performed.

According to an embodiment of the present invention, an aqueous solution of carbon precursor (CH₃CN, acetonitrile) and aliphatic hydrocarbon derivatives (ethanol, methanol, etc.) are used as a precursor for diamond.

Also, the AAO nanotemplate has uniformly sized holes (size: 1 ∼ 1,000 nm) and uses one of Co, Ni, Fe, Pt, and etc. as a catalyst metal.

Hereinafter, a method of manufacturing a hexagonal nanoplate diamond in an AAO nanotemplate that has a plurality of holes of various sizes of 1 ∼ 1,000 nm, using an electrochemical method will be described.

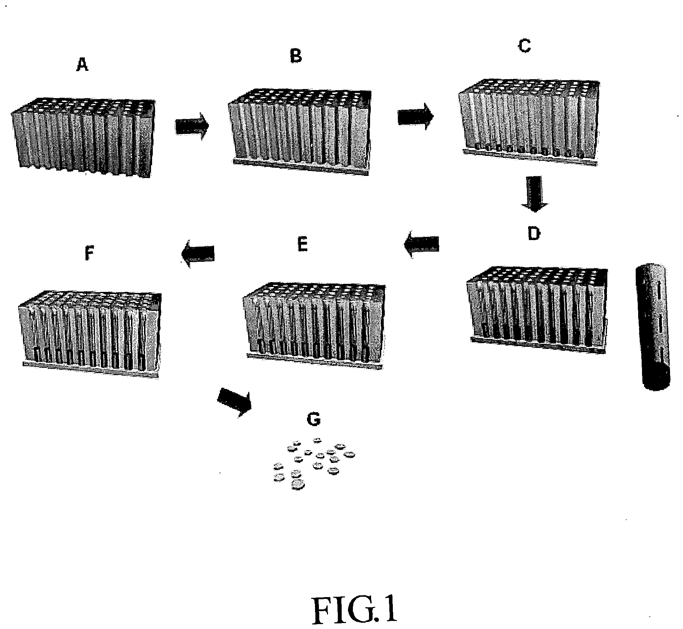

FIG. 1 is a schematic diagram illustrating a process for manufacturing a nanoplate diamond according to an embodiment of the present invention.

The step A in FIG. 1 illustrates providing a nanotemplate. An AAO nanotemplate or a polymer nanotemplate is used as a nanotemplate.

The AAO nanotemplate has a plurality of holes. According to an embodiment of the present invention, the plurality of holes may have a size of 1 ∼ 1,000 nm depending on a size of a diamond to be formed. For example, an amorphous AAO nanotemplate having a plurality of holes with a size of 200 nm may be used, as shown in the figure.

The step B in FIG. 1 illustrates depositing a conductor that will be used as an electrode for the AAO nanotemplate. For example, one of Au, Ag and Cu is coated as a conductor at the bottom of the AAO nanotemplate to the thickness of about 200 nm, as shown in the figure. A method for the deposition includes a thermal evaporation. The Au coating layer serves as an anode in an electrodeposition. A conductive material such as an indium-tin oxide and a metal through which an electric current flows may be used as an anode.

The step C in FIG. 1 illustrates uniformly forming a metal nano-wire of Co, Ni, Fe or Pt on the Au layer in every hole of a nanotemplate using electrodeposition. For example, a Co nanorod, which is a catalyst for forming a diamond, is electrodeposited on the Au layer, as shown in the figure.

The step D in FIG. 1 illustrates an initial step for forming a diamond. A carbon based aqueous solution is used as a precursor material for forming a diamond. An acetonitrile (CH₃CN) and aliphatic hydrocarbon derivatives (ethanol, methanol, etc.) are added as a precursor material. Then, electric current flows for a predetermined time with a DC voltage regulated between 0 V and 50 V or with an electric current regulated between 0 mA and 20 mA. At this time, the hole of the nanotemplate serves as a passageway supplying a predetermined electric current. The figure to the right of step D shows a single hole and arrows inside the hole, the arrows representing a direction of an electric current.

The step E in FIG. 1 illustrates forming a hexagonal diamond in a hole of an AAO nanotemplate. Acetonitrile (CH₃CN) is used as a precursor material for carbon. Aliphatic hydrocarbon derivatives (ethanol, methanol, etc.) may also be used as a precursor material for carbon. The electroplating is carried out under the condition that a voltage is 15 V and a distance between a cathode and an anode is 0.5 cm.

The step F in FIG. 1 illustrates hexagonal diamonds formed in every hole of the AAO nanotemplate. After about 3 hours of electroplating, the formation of diamonds is completed.

The step G in FIG. 1 illustrates pure hexagonal diamond nanoplates separated from the AAO nanotemplate by dissolving in NaOH 1 M solution. The pure hexagonal diamond nanoplates could be separated by dissolving the anodic oxide nanotemplate in sodium hydroxide (NaOH) 1M solution at normal temperature for one hour and applying ultrasonic vibrations thereto. Thereby a hexagonal nanoplate diamond could be obtained.

This method of manufacturing a hexagonal nanoplate diamond has the benefits of a simple fabrication process, a low fabrication cost, an excellent reproducibility, and above all, an easy size control of a diamond nanoplate. A diameter of a nanoplate can be controlled by an AAO nanotemplate having holes of different sizes, and the thickness of a nanoplate can be controlled by changing time duration of electroplating.

Raman spectroscopy studies of the nanoplate diamond thus formed showed a peak at 1368 cm⁻¹, indicative of a diamond having sp³ bonding.

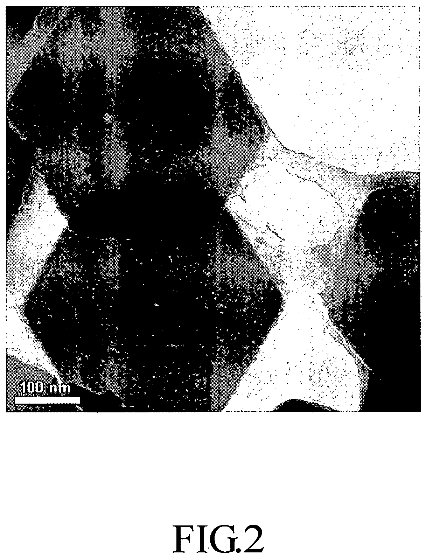

FIG. 2 is a transmission electron micrograph of a hexagonal nanoplate diamond that is formed using a method according to an embodiment of the present invention, which shows that the nanoplate diamond is a hexagonal diamond.

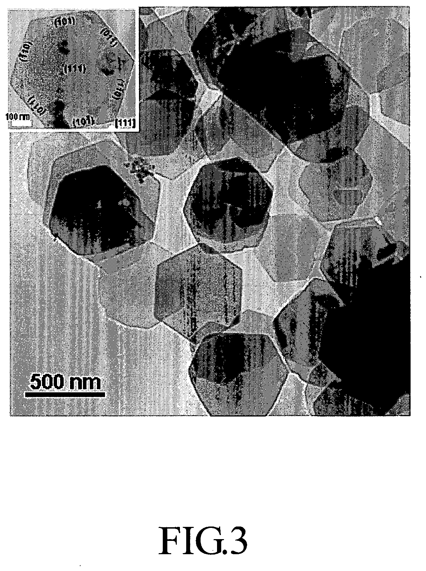

FIG. 3 is a photograph showing a plurality of hexagonal nanoplate diamonds that is uniformly grown using a method according to an embodiment of the present invention. And a transmission electron micrograph of a diamond single crystal illustrating plane directions of one of hexagonal nanoplate diamonds is also shown at the top left of the figure. Here, the hexagonal diamond plate structure shows hexagonal planes of diamond single crystal that is grown very uniformly. Plane directions are shown in a photograph of a single hexagonal diamond nanoplate at the top left of FIG. 3. The upper and lower surfaces have <111> directions, and the facets of the hexagon have <110> directions to constitute side surfaces of the hexagonal diamond single crystal.

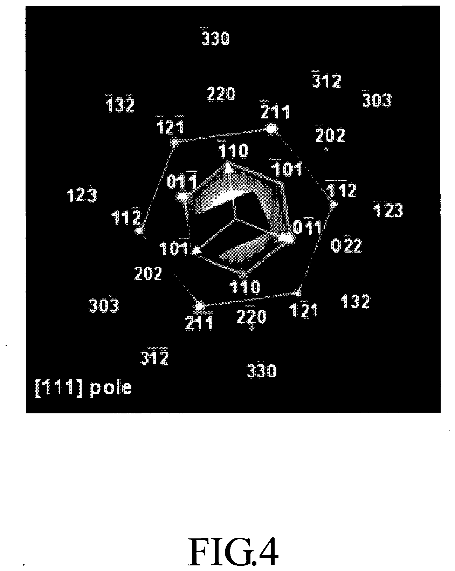

FIG. 4 is a photograph showing an electron diffraction pattern of a hexagonal nanoplate diamond formed using a method according to an embodiment of the present invention, which shows that the diamond is grown to be a single crystal. That is, FIG. 4 shows a selected area electron diffraction pattern of a hexagonal plate diamond. The distinct diffraction spots that are divided and arranged well show the diamonds in FIG. 2 to be a single crystal.

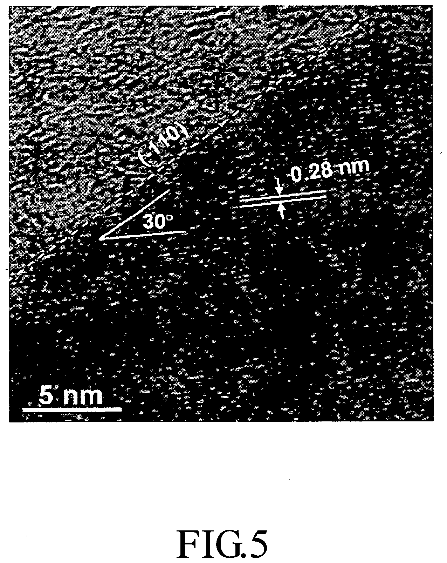

FIG. 5 is a high resolution electron micrograph showing a lattice structure of a hexagonal nanoplate diamond formed using a method according to an embodiment of the present invention, which shows that side surfaces are at 30 degrees with respect to the (111) plane and a fringe spacing is 0.28 nm. That is, FIG. 5 shows lattice structures, i.e., crystallographic relations, of the surfaces. Referring to FIG. 5, each side surface is projected at an angle of 30 degree with respect to the (111) plane and fringe spacing is 0.28 nm.

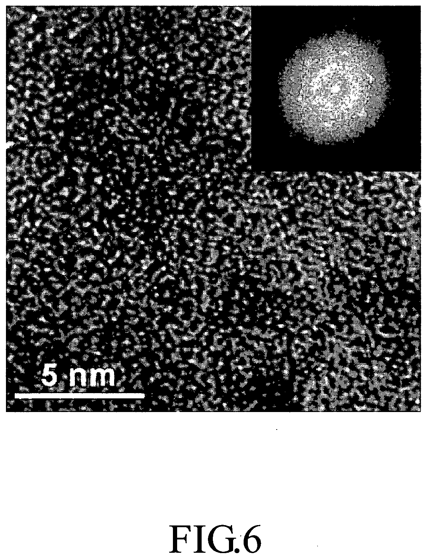

FIG. 6 is a high resolution electron micrograph of a hexagonal nanoplate diamond formed using a method according to an embodiment of the present invention, and a photograph showing a Fourier transformation pattern of [111] projection lattice is also shown at the top right of the figure. Referring to FIG. 6, the Fourier transformation pattern of [111] projection lattice at the top right of the figure has a hexagonal shape, which is well matched to the fringe spacing of 0.28 nm and exhibits six-axis symmetry that could be distinguished by a second reflection.

As described above, it is expected that a single crystal diamond nanoplate formed to have a uniform surface, size, thickness and shape according to an embodiment of the present invention makes it easier to apply the mechanical, surface, physicochemical, biological, optical or electronic property of a diamond to industrial applications.

A method for electrochemically synthesizing a hexagonal nanoplate diamond according to an embodiment of the present invention does not require a high temperature heat treatment, thus provides a simple and economical method for manufacturing a diamond in comparison with conventional methods. Further, the method for electrochemically synthesizing a hexagonal nanoplate diamond according to an embodiment of the present invention provides a nanoplate diamond having a more uniform surface, thickness, size and shape compared with conventional methods.

## Claims

1. A method of manufacturing a nanoplate diamond, the method comprising the steps of:
providing a nanotemplate having a plurality of holes;
forming a nanoplate diamond in the nanotemplate using an electrochemical method; and
separating the nanoplate diamond by removing the nanotemplate.

2. The method of claim 1, wherein one of Au, Ag and Cu is used as a conductor in the electrochemical method.

3. The method of claim 1, further comprising the step of depositing a catalyst metal for forming the nanoplate diamond on the nanotemplate after the step of providing the nanotemplate.

4. The method of claim 3, wherein the catalyst metal is one selected from the group consisting of Co, Ni, Fe and Pt.

5. The method of claim 3, wherein an aqueous solution of carbon precursor (CH₃CN, acetonitrile) and aliphatic hydrocarbon derivatives (Organics such as ethanol, methanol, etc.) are used as a precursor for diamond.

6. The method of claim 1, wherein the nanotemplate comprises an anodized aluminum oxide nanotemplate.

7. The method of claim 1, further comprising the step of depositing a conductor at a bottom of the nanotemplate.

## Patentansprüche

1. Verfahren zur Herstellung eines Nanokristalldiamanten, wobei das Verfahren die folgenden Schritte umfasst
Bereitstellen eines Nanotemplates mit einer Vielzahl von Löchern;
Bilden eines Nanokristalldiamanten in dem Nanotemplate unter Verwendung eines elektrochemischen Verfahrens; und
Abtrennen des Nanokristalldiamanten durch Entfernen des Nanotemplates.

2. Verfahren nach Anspruch 1, wobei entweder Au oder Ag oder Cu als Leiter bei dem elektrochemischen Verfahren verwendet wird.

3. Verfahren nach Anspruch 1, ferner umfassend den Schritt des Abscheidens eines Katalysatormetalls zum Bilden des Nanokristalldiamanten auf dem Nanotemplate nach dem Schritt des Bereitstellens des Nanotemplates.

4. Verfahren nach Anspruch 3, wobei das Katalysatormetall aus der Gruppe, bestehend aus Co, Ni, Fe und Pt, ausgewählt ist.

5. Verfahren nach Anspruch 3, wobei eine wässrige Lösung eines Kohlenstoffvorläufers (CH₃CN, Acetonitril) und aliphatischer Kohlenwasserstoffderivate (organische Stoffe wie Ethanol, Methanol, etc.) als Vorläufer für Diamanten verwendet wird.

6. Verfahren nach Anspruch 1, worin das Nanotemplate ein eloxiertes Aluminiumoxid-Nanotemplate umfasst.

7. Verfahren nach Anspruch 1, ferner umfassend den Schritt des Abscheidens eines Leiters an einem Boden des Nanotemplates.

## Revendications

1. Procédé de fabrication de nanocristaux de diamant, le procédé comprend les étapes consistant à:
mettre à disposition un nano-gabarit comportant une pluralité de trous;
former des nanocristaux de diamant dans le nano-gabarit selon un procédé électrochimique; et
séparer les nanocristaux de diamant par retrait du nano-gabarit.

2. Procédé selon la revendication 1, en ce que soit de l'Au, Ag ou Cu est utilisé comme conducteur dans le procédé électrochimique.

3. Procédé selon la revendication 1, comprenant en outre l'étape consistant à déposer un métal catalyseur pour former les nanocristaux de diamant sur le nano-gabarit après l'étape consistant à fournir le nano-gabarit.

4. Procédé selon la revendication 3, en ce que le métal catalyseur est un métal sélectionné dans le groupe constitué de Co, Ni, Fe et Pt.

5. Procédé selon la revendication 3, en ce qu'une solution aqueuse de précurseur de carbone (CH₃CN, acétonitrile) et des dérivés hydrocarbure aliphatique (matières organiques comme éthanol, méthanol, etc.) sont utilisés comme précurseur de diamant.

6. Procédé selon la revendication 1, en ce que le nano-gabarit comprend un nano-gabarit d'oxyde d'aluminium anodisé.

7. Procédé selon la revendication 1, comprenant en outre l'étape consistant à déposer un conducteur sur une partie inférieure du nano-gabarit.
